# DEMANDE DE BREVET EUROPEEN

(11) **EP 2 605 188 A1**
(43) Date de publication de la demande: **19.06.2013**
(21) Numéro de dépôt: 11306663.3
(22) Date de dépôt: 14.12.2011
(51) Int. Cl.: G06K 19/077

(54) **Procédé de fabrication de cartes à puce**

(71) Demandeur: Gemalto SA, 92190 Meudon (FR)
(72) Inventeur: Ottobon, Stéphane, 92190 Meudon (FR); Dossetto, Lucile, 92190 Meudon (FR)

(57) **Abrégé**

La présente invention concerne un procédé de fabrication de carte à puce 1 permettant de diminuer l'épaisseur de ladite carte à puce et d'obtenir directement un format final 3FF ou 4FF. Le procédé de fabrication de carte à puce comporte les étapes de dépôt d'une résine formant une première couche de protection 11 sur l'ensemble des éléments électroniques et dont la surface est supérieure au format désiré de la carte à puce et de dépôt sur la première couche de protection une deuxième couche de protection dont la surface est supérieure au format désiré de la carte à puce. La fixation de la deuxième couche de protection sur la première couche de protection se fait en polymérisant la première couche de protection, puis, on découpe l'ensemble ainsi obtenu au format désiré.

## Description

La présente invention se rapporte à un procédé de fabrication de cartes à puce au format 2FF, 3FF ou 4FF UICC (de l'anglais Universal Integrated Circuit Card). Les cartes à puces peuvent être par exemple des cartes SIM.

Pour fabriquer des cartes SIM on utilise en général la méthode de l'encartage. Cette méthode consiste dans un premier temps à encapsuler un ensemble de composants électroniques comprenant une puce électronique et des fils de connexion dans une résine afin d'assurer leur protection composants du module électronique. Cet ensemble est ensuite collé au sein d'une cavité d'un boîtier en matière plastique par exemple. Ce boîtier est souvent appelé « corps de carte ».

Le format des cartes SIM est de plus en plus petit et leur épaisseur de plus en plus fine avec la miniaturisation et l'augmentation des fonctionnalités des téléphones portables. Le passage du facteur de forme 2FF (25 x 15 mm²) au 3FF (15 x 12 mm²) et prochainement au 4FF réduit la surface collage de celui-ci soit la taille des composants que l'on peut intégrer au module.

D'autre part, la diminution de l'épaisseur des cartes SIM est à l'étude afin de diminuer le volume de la carte SIM dans son lecteur et également afin de permettre l'insertion de cette SIM de dimension réduite dans des adaptateurs permettant la compatibilité avec les connecteurs de lecteurs utilisant des formats plus anciens.

Un inconvénient de la méthode standard d'encartage est qu'elle ne permet pas de réduire facilement l'épaisseur des cartes SIM en dessous des 0,80mm actuels. Dans cette méthode, la résine encapsulant l'ensemble de composants électroniques peut présenter des irrégularités de surface et une topologie avec des différences de hauteurs trop importantes pour être livrée a des clients comme un produit fini. D'autre part ce relief de surface ne respecte pas les tolérances d'épaisseurs des mini cartes ou autres boîtiers de circuit intégré (« packages » en anglais).

Pour pallier au problème d'irrégularités de surface, la méthode standard prévoit d'insérer l'ensemble de composants électroniques encapsulé - appelé module - dans un corps de carte. Cependant cette solution augmente l'épaisseur de la carte à puce. En effet, il faut prendre en compte un empilement d'adhésif thermofusible (« hotmelt » en anglais) pour coller le module électronique au corps de carte, du vide entre le module et le fond de la cavité de la carte, et de l'épaisseur du fond de cavité de la carte. Cet empilement représente au minimum 0,15mm limitant de fait la possibilité de diminution de l'épaisseur.

Un inconvénient supplémentaire est que le corps de carte fabriqué selon la norme ISO en vigueur a un format étendu par rapport au format final de la carte SIM quelque soit le format final de cette carte. Ceci limite donc la surface utile de la carte à puce c'est-à-dire la surface disponible pour les composants électroniques. Le corps de carte est prédécoupé autour de la carte SIM, et l'utilisateur sépare les deux avant de pouvoir utiliser la carte SIM. L'encartage nécessite donc d'utiliser une grande quantité de plastique, ce qui augmente le coût de cette méthode.

Le document WO 2010/094782 A1 divulgue une méthode pour la fabrication de carte à puce sans recourir à l'encartage. Le module électronique est recouvert d'une couche de résine dont les dimensions sont légèrement supérieures à celles du format final de la carte à puce. Cette couche de résine constitue le boîtier de la carte à puce à elle seule.

Un inconvénient est que la résine est dispensée grâce à un procédé de moulage par transfert de résine (« Resin Transfer Molding » ou RTM en anglais), ce qui nécessite un investissement coûteux dans un équipement spécialisé.

Le document EP 0644507 B1 divulgue une méthode ainsi qu'un dispositif pour la fabrication de module de carte à puce destiné à être ensuite encarté. Dans cette méthode, le module électronique comporte une plaquette de recouvrement dont une face est enduite de résine. La plaquette enduite est apposée sur le module électronique de telle sorte que la résine recouvre le module électronique. Cette méthode permet de réduire l'épaisseur finale du module à 0,62mm mais nécessite toujours d'encarter le module et donc d'avoir une épaisseur additionnelle de plastique qui s'ajoute à l'épaisseur du module.

Un autre inconvénient est qu'elle nécessite un dispositif spécifique, ce qui entraîne une augmentation des coûts.

Un des buts de l'invention est de remédier au moins partiellement aux inconvénients de l'art et donc de proposer un procédé de fabrication de carte SIM permettant une réduction significative de son épaisseur sans investir dans un équipement coûteux.

La présente invention consiste en un procédé de fabrication de cartes à puce, comprenant un film support diélectrique ayant sur une première face au moins une zone de contact électrique et ayant sur une seconde face opposée à la première un groupe d'éléments électroniques comportant au moins une puce électronique et des fils de connexion, la puce électronique étant connectée à ladite au moins une zone de contact électrique par les fils de connexion passant par un premier ensemble d'orifices dans le film support diélectrique, **caractérisé en ce que** ledit procédé comprend les étapes suivantes :
- on applique sur la seconde face du film support diélectrique une résine de protection formant une première couche de protection dont l'épaisseur correspond au moins à l'extension maximale dudit groupe d'éléments électroniques dans une direction perpendiculaire au plan défini par ledit film support diélectrique, et dont la surface selon le plan du film support diélectrique est supérieure au format désiré de la carte à puce,
- on dépose sur la première couche de protection une seconde couche de protection au moins au niveau de la puce électronique et dont la surface selon le plan du film support diélectrique est supérieure au format désiré de la carte à puce,
- on fixe la deuxième couche de protection sur la première couche de protection en polymérisant la première couche de protection.
- on découpe l'ensemble ainsi obtenu au format désiré.

Selon un aspect de l'invention, la deuxième couche de protection est réalisée sous forme d'une pastille individuelle ayant un format légèrement supérieur au format final de la carte à puce.

Selon un autre aspect de l'invention, la deuxième couche de protection est réalisée sous forme d'un film s'étendant sur l'ensemble du support diélectrique comprenant une pluralité de modules électroniques.

Selon un autre aspect de l'invention, avant l'application de la première couche de protection, on fixe des étais de même taille sur la zone de contact électrique à travers le premier ensemble d'orifices du film support diélectrique dans une direction perpendiculaire au plan défini par le film support diélectrique.

Selon un autre aspect de l'invention, on applique la première couche de protection d'une épaisseur au moins égale à l'extension maximale des étais dans la direction perpendiculaire au plan défini par le film support diélectrique.

Selon un autre aspect de l'invention, on réalise la deuxième couche de protection en verre époxy ou en matériau plastique ou thermostable.

Selon un autre aspect de l'invention, on personnalise graphiquement la deuxième couche de protection avant d'être déposées sur la première couche de protection.

La présente invention consiste aussi en une carte à puce comprenant un film support diélectrique ayant sur une première face au moins une zone de contact électrique et ayant sur une seconde face opposée à la première une surface utile sur laquelle est disposé un ensemble d'éléments électroniques comportant au moins une puce électronique et des fils de connexion, la puce électronique étant connectée à ladite au moins une zone de contact électrique par les fils de connexion passant par un premier ensemble d'orifices dans le film support diélectrique, **caractérisé en ce que**:
- elle comporte une première couche de protection sur la seconde face du film support diélectrique, dont l'épaisseur est au moins égale à la hauteur maximale de l'ensemble de composants électroniques,
- elle comporte une deuxième couche de protection sur la première couche de protection,
- la surface utile s'étend sur toute la surface de la carte à puce.

Selon un aspect de l'invention, la carte à puce possède des étais dont la hauteur est au moins égale à celle du plus haut composant de l'ensemble de composants électroniques et sur lesquels est posée la deuxième couche de protection.

D'autres caractéristiques et avantages apparaîtront plus clairement à la lecture de la description qui suit et à l'examen des figures qui l'accompagnent parmi lesquelles :
- La figure 1 montre une représentation schématique d'une coupe transversale d'une carte à puce selon la présente invention.
- La figure 2 montre une représentation schématique d'une coupe transversale d'une variante de la carte à puce selon la présente invention.
- La figure 3 représente une vue de dessus du film de support des supports de données électroniques avant la découpe.
- La figure 4 représente un organigramme illustrant les étapes du procédé de fabrication de la carte à puce.
- Les figures 5a, 5b, 5c et 5d montrent une représentation schématique de la réalisation d'un boîtier contenant une carte à puce.
- Les figures 6a, 6b, et 6c montrent une surface utile de la carte à puce selon l'art antérieur et selon la présente invention.

Les mêmes éléments portent la même référence sur les différentes figures.

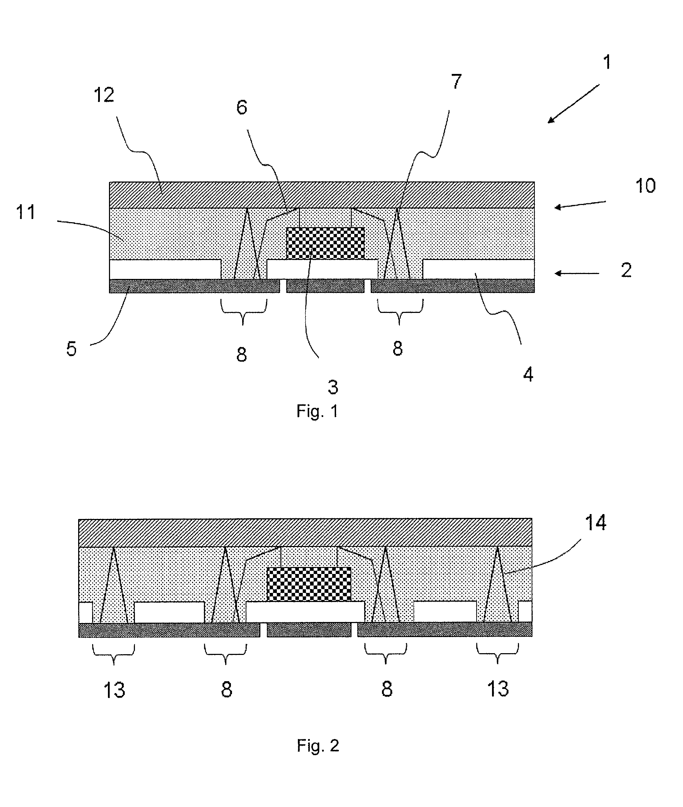

La figure 1 représente le format final d'une carte à puce 1 en coupe. Ladite carte à puce est composée de deux ensembles : d'une part un ensemble de composants électroniques 2 et d'autre part un boîtier 10. Ledit ensemble de composants électroniques 2 comprend un film support diélectrique 4 ayant au moins une zone de contact électrique 5 sur une première face et ayant une puce électronique 3 fixée sur une seconde face opposée à la première. La puce électronique 3 est connectée à la zone de contact électrique par des fils de connexion 6 passant par des orifices 8 dans le film support diélectrique 4. L'assemblage de l'ensemble de composants électronique sur le film support diélectrique est un procédé bien connu du milieu des supports de données électronique et n'entre pas dans le cadre de ce brevet.

Le boîtier 10 comprend des étais 7, une première couche de protection 11 et une deuxième couche de protection 12. Les étais 7 sont des fils métalliques de même taille et sont de hauteur supérieure à la puce 3 et au moins égale à celle des fils de connexion 6. Les étais 7 sont fixés par exemple par soudage sur la zone de contact électrique 5 à travers les orifices 8 permettant également le passage des fils de connexion 6.

La première couche de protection 11 est située sur la seconde face du film support diélectrique 4 recouvre la puce électrique 3, les fils de connexion 6 et les étais 7. Ladite première couche de protection 11 est une résine par exemple de type époxy.

La deuxième couche de protection 12 est située sur la première couche de protection 11. Ladite deuxième couche de protection 12 peut être composée de verre époxy ou en matériau thermosplastique ou thermostable (PET, PEN) ou thermodurcissable. Les dimensions de la carte à puce étant faibles, les marges de tolérances sont plus strictes. Ladite deuxième couche de protection permet d'obtenir une fiabilité mécanique et thermomécanique supérieure à celle apportée par une résine dispensée seule et donc de mieux respecter les tolérances imposées. De plus par rapport à ladite première couche de protection, ladite deuxième couche de protection possède une surface beaucoup plus plane et régulière qui permet de respecter les tolérances d'épaisseur des cartes à puce de format 3FF ou 4FF.

L'épaisseur totale de la carte à puce 1 correspond ainsi à l'épaisseur de la première couche de protection 11 additionnée à l'épaisseur de la deuxième couche de protection 12, à l'épaisseur du film support diélectrique 4 et à l'épaisseur de la zone de contact électrique 5.

La figure 2 montre une variante de l'invention. Selon cette variante, il y a un deuxième ensemble d'orifices 13 à travers le film support diélectrique 4 et jusqu'à la zone de contact électrique 5. Ces orifices ne sont pas utilisés pour établir une connexion électrique entre la puce électronique 3 et la zone de contact électrique 5. Des étais supplémentaires 14 sont soudés sur la zone de contact électrique 5 à travers le deuxième ensemble d'orifices 13. Leur taille est égale à celle des étais 7 soudés à travers le premier ensemble d'orifices 8. Ces étais supplémentaires servent à améliorer la coplanarité de la carte à puce.

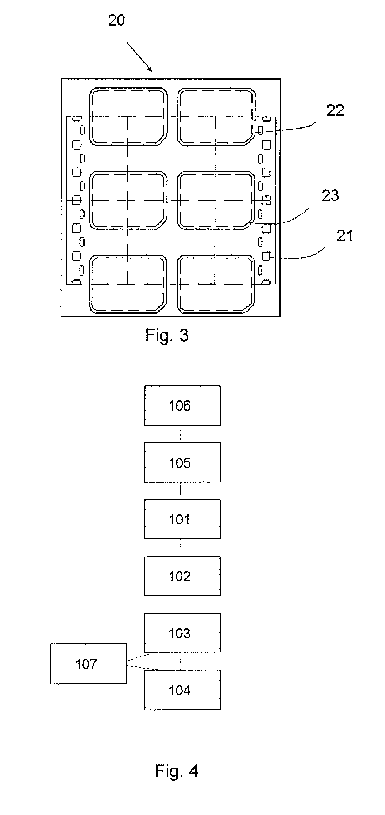

La figure 3 représente une vue de dessus du film de support flexible 20 sur lequel sont situés les cartes à puce 1 avant d'être découpées. Le film de support flexible comporte des trous d'indexation 21 pour l'assemblage et comme référence de découpe. Le format final 23 de la carte à puce 1 est légèrement inférieur au format 22 de la deuxième couche de protection 12. La découpe a lieu suivant le format 2FF, 3FF ou 4FF de la carte à puce 1.

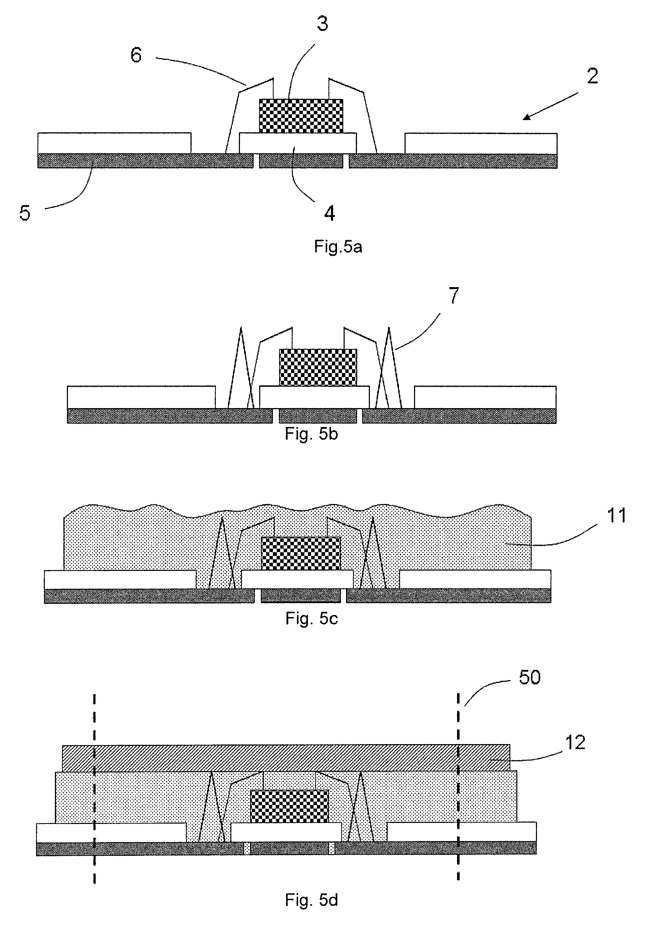

La figure 4 montre un organigramme illustrant les étapes de la réalisation du boîtier 10 de carte à puce 1 tel que représenté sur la figure 1. Les figures 5a à 5d illustrent certaines étapes de cette réalisation.

L'ensemble de composants électroniques 2 tel que fourni est représenté sur la figure 5a. Ledit ensemble de composants électroniques est fourni sur un support flexible contenant une pluralité d'ensembles de composants électroniques.

Au cours d'une étape facultative 105 (figure 5b) on fixe des étais 7 sur la zone de contact électrique à travers les orifices servant à laisser passer les fils de connexion et dans une direction perpendiculaire au plan formé par le film support diélectrique. Les étais peuvent être réalisés par exemple en fil d'or, de cuivre, d'aluminium ou de palladium. Les étais servent à assurer un meilleur parallélisme entre les deux surfaces extérieures de la carte à puce (deuxième couche de protection et zone de contact électrique).

Au cours d'une étape 101 (figure 5c), une première couche de protection 11 est appliquée sur l'ensemble de composants électroniques et les étais 7. Comme dit précédemment, cette première couche de protection 11, dispensée sous la forme d'une résine recouvre la puce 3, les fils de connexion 6, les étais 7 et le film support diélectrique 4. La zone qu'elle recouvre sur le film support diélectrique 4 est supérieure au format final de la carte à puce 1. La résine peut être appliquée en utilisant des équipements standard de dispense. La dispense de la première couche de protection 11 peut être optimisée en utilisant une dispense en trajet ou avec une vanne multi-trous. La résine est dispensée sur des zones individuelles recouvrant le module électronique et de surface légèrement plus étendue par exemple de quelques mm² que la carte à puce qui sera découpée de façon à garder une flexibilité possible du support de module. A l'issue de cette étape, ladite première couche de protection 11 présente des irrégularités de surface.

Selon une variante de l'invention, la première couche de protection 11 peut recouvrir plusieurs modules électroniques formant ainsi des plaques qui seront découpées par exemple en plusieurs boîtiers de circuits intégrés par exemple pour carte à mémoire Flash ou autre type de boitier disposant de contacts sur une seule face.

Au cours d'une étape 102 (figure 5d), on dépose une deuxième couche de protection 12 sur la première couche de protection 11 au moins au niveau de la puce électronique 3 et dont le format selon le plan du film support est supérieure au format final de la carte à puce, par exemple d'1mm. La deuxième couche de protection 12 est fournie sous forme de pastilles individuelles. Un équipement standard de dépôt de pastilles peut être utilisé. La pastille est déposée sur la résine non polymérisée. Ladite pastille constitue une surface extérieure de la carte à puce.

Au cours d'une étape 103, on fixe la deuxième couche de protection 12 sur la première couche de protection 11 en polymérisant la première couche de protection. Lors de ladite étape 103, la deuxième couche de protection vient se poser sur les étais 7. Cette polymérisation peut être réalisée par exemple dans un four à passage ou/et une étuve.

Selon une variante, la deuxième couche de protection est fournie sous forme de film de protection qui est laminé de façon collective sur la première couche de protection 11.

Au cours d'une étape 104, on découpe la carte à puce 1 afin d'obtenir son format final. Les lignes de découpe 50 sont représentées sur la figure 5d. Les technologies de découpe qui peuvent être utilisées incluent, mais ne se limitent pas à la découpe laser, la découpe mécanique, la découpe par jet d'eau etc... Etant donné que les première et deuxième couches de protection ont un format supérieur au format de la carte à puce 1, on découpe donc à travers les première et deuxième couches de protection ainsi qu'à travers le support flexible.

Le procédé de fabrication peut aussi comporter une étape 106 avant l'étape 105 lors de laquelle on perce un deuxième ensemble d'orifices 13 à travers le film support diélectrique répartis sur la zone de contact électrique de façon à la découvrir partiellement. Des étais supplémentaires 14 sont fixés sur la zone de contact électrique à travers le deuxième ensemble d'orifices dans une direction perpendiculaire au plan formé par le film support diélectrique. Les étais supplémentaires sont répartis sur toute la zone de contact électrique, leur nombre dépend du format de carte à puce désiré.

L'épaisseur de la carte à puce peut être ajustée en fonction de l'épaisseur finale voulue. Pour ajuster cette épaisseur on peut ajuster la hauteur des étais 7, 14 et/ou l'épaisseur de la deuxième couche de protection 12. Le film de support peut aussi posséder un évidement dans le diélectrique au niveau de la carte la puce pour réduire l'épaisseur finale de la carte à puce.

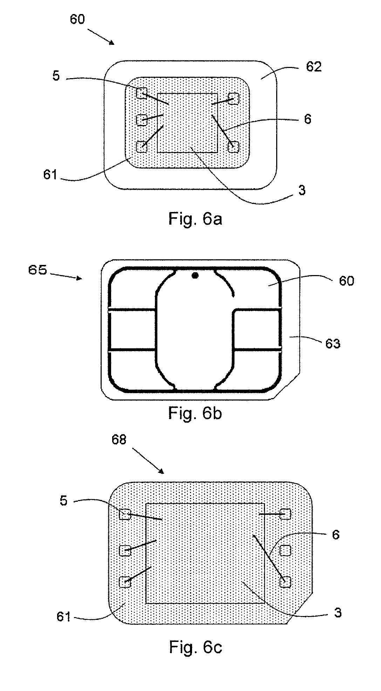

Dans le cas où on ne cherche pas à réduire l'épaisseur de la carte à puce, le gain de surface peut être utilisé pour maximiser la taille des composants du module. Ce gain de surface obtenu est illustré par les figures 6a, 6b et 6c.

La figure 6a montre une vue de dessous d'un module standard 60 destiné à être encarté dans un corps de carte. La surface utile 61 de la carte, c'est-à-dire la surface pouvant accueillir des composants électroniques, est limitée par la surface de collage 62 nécessaire afin de pouvoir fixer le module dans le corps de carte.

La figure 6b représente une carte à puce réalisée selon la méthode standard d'encartage 65. On peut voir une vue de dessus du module standard 60, ainsi que le corps de carte 63.

La figure 6c montre la surface utile 61 de la carte à puce réalisée selon la présente invention 68. On peut voir que, contrairement à la méthode standard d'encartage, ladite surface utile 61 s'étend sur toute la surface de la carte à puce 68. Ce gain de surface permet donc de maximiser la taille des composants électroniques, par exemple la puce électronique 3.

Le procédé de fabrication peut aussi comporter une étape 107 de personnalisation graphique de la deuxième couche de protection. Cette personnalisation est réalisée après l'étape 103, quand la deuxième couche de protection a été déposée sur la première couche de protection et avant l'étape 104 de découpe. La personnalisation graphique peut être faite par laser ou jet d'encre. Selon une variante, une étiquette peut être collée sur les pastilles formant la deuxième couche de protection 12. Selon une autre variante les pastilles peuvent être décorées de façon collective en rouleau avant d'être découpées et disposées sur la première couche de protection 11.

Ce procédé est particulièrement adapté à la fabrication de cartes à puce 3FF et 4FF car il permet de fabriquer un boîtier électronique de format réduit. Ce procédé peut être mis en oeuvre en utilisant les équipements classiques de l'industrie de la carte à puce. Ce procédé peut également être utilisé pour réaliser à moindre coût des boitiers de circuits intégrés ayant un facteur de forme proche de celui d'une carte. D'autre part, ce procédé permet de fabriquer les cartes à puce directement à leur format final.

## Revendications

1. Procédé de fabrication de carte à puce (1), comprenant un film support diélectrique (4) ayant sur une première face au moins une zone de contact électrique (5) et ayant sur une seconde face opposée à la première un ensemble d'éléments électroniques (2) comportant au moins une puce électronique (3) et des fils de connexion (6), la puce électronique (3) étant connectée à ladite au moins une zone de contact électrique (5) par les fils de connexion (6) passant par un premier ensemble d'orifices (8) dans le film support diélectrique (4), **caractérisé en ce que** ledit procédé comprend les étapes suivantes :
• on applique sur la seconde face du film support diélectrique (4) une résine de protection formant une première couche de protection (11) dont l'épaisseur correspond au moins à l'extension maximale dudit ensemble d'éléments électroniques (2) dans une direction perpendiculaire au plan défini par ledit film support diélectrique (4), et dont la surface selon le plan du film support diélectrique (4) est supérieure au format désiré de la carte à puce,
• on dépose sur la première couche de protection (11) une seconde couche de protection (12) au moins au niveau de la puce électronique et dont la surface selon le plan du film support diélectrique (4) est supérieure au format désiré de la carte à puce,
• on fixe la deuxième couche de protection sur la première couche de protection en polymérisant la première couche de protection,
• on découpe l'ensemble ainsi obtenu au format désiré.

2. Procédé de fabrication selon la revendication 1, **caractérisé en ce qu'**on réalise la deuxième couche de protection (12) sous forme d'une pastille individuelle ayant un format légèrement supérieur au format final de la carte à puce.

3. Procédé de fabrication selon la revendication 1, **caractérisé en ce qu'**on réalise la deuxième couche de protection (12) sous forme d'un film s'étendant sur l'ensemble du support comprenant une pluralité d'ensembles de composants électroniques .

4. Procédé de fabrication selon l'une la revendication 1, **caractérisé en ce qu'**avant l'application de la première couche de protection (11), on fixe des étais (7) de même taille sur la zone de contact électrique (5) à travers le premier ensemble d'orifices (8) du film support diélectrique (4) dans une direction perpendiculaire au plan défini par le film support diélectrique.

5. Procédé de fabrication selon la revendication 4, **caractérisé en ce qu'**on applique la première couche de protection (11) d'une épaisseur au moins égale à l'extension maximale des étais (7, 14) dans la direction perpendiculaire au plan défini par le film support diélectrique.

6. Procédé de fabrication selon la revendication 1, **caractérisé en ce qu'**on réalise la deuxième couche de protection (12) en verre époxy ou en matériau plastique ou thermostable.

7. Procédé de fabrication selon la revendication 1, **caractérisé en ce qu'**on personnalise graphiquement la deuxième couche de protection (12) avant d'être déposées sur la première couche de protection (11).

8. Carte à puce comprenant un film support diélectrique (4) ayant sur une première face au moins une zone de contact électrique (5) et ayant sur une seconde face opposée à la première une surface utile (61) sur laquelle est disposée un ensemble d'éléments électroniques (2) comportant au moins une puce électronique (3) et des fils de connexion (6), la puce électronique (3) étant connectée à ladite au moins une zone de contact électrique (5) par les fils de connexion (6) passant par un premier ensemble d'orifices (8) dans le film support diélectrique (4), **caractérisé en ce que**:
• elle comporte une première couche de protection (11) sur la seconde face du film support diélectrique (4), dont l'épaisseur est au moins égale à la hauteur maximale de l'ensemble de composants électroniques (2),
• elle comporte une deuxième couche de protection (12) sur la première couche de protection,
• la surface utile (61) s'étend sur toute la surface de la carte à puce (1).

9. Carte à puce (1) selon la revendication 8, **caractérisée en ce qu'**elle comporte des étais (7) dont la hauteur est au moins égale à celle du plus haut composant de l'ensemble de composants électroniques (2) et sur lesquels est posée la deuxième couche de protection (12).
